# EUROPEAN PATENT APPLICATION

(11) **EP 2 173 146 A1**
(43) Date of publication of application: **07.04.2010**
(21) Application number: 07790801.0
(22) Date of filing: 13.07.2007
(51) Int. Cl.: H05K 3/46

(54) **WIRING BOARD AND MANUFACTURING METHOD THEREOF**

(71) Applicant: Ibiden Co., Ltd., Ogaki-shi, Gifu 503-8604 (JP)
(72) Inventor: TAKAHASHI, Michimasa, Ogaki-shi Gifu 503-8503 (JP); AOYAMA, Masakazu, Ogaki-shi Gifu 503-8503 (JP)
(74) Representative: Gendron, Vincent Christian
(86) International application number: PCT/JP2007/064021
(87) International publication number: WO 2009/011023

(57) **Abstract**

A wiring board 19 is structured by laminating first substrate 1, second substrate 2 having a smaller mounting area than that of first substrate 1, and base substrate 3 formed between first substrate 1 and second substrate 2. The thickness of at least a portion of the periphery is made less than that of the central portion. Base substrate 3 is formed with resin containing inorganic filler, and first substrate 1 and second substrate 2 are formed with pliable resin. Vias 44 are formed in the first substrate 1 and the second substrate 2. An interlayer groove section 11 is formed between the first substrate 1 and the second substrate 2. In the interlayer groove section 11, gas or the like is filled.

## Description

### Technical Field

The present invention relates to a wiring board formed by combining multiple boards each having a different mounting area, and a method of manufacturing such a wiring board.

### Background Art

Among electronic devices, some are preferred to be made compact and lightweight; cell phones especially are expected to be made thin in addition to being made compact and lightweight. Also, wiring boards for use in cell phones are expected to be made compact, lightweight and thin.

However, if a wiring board is made thin, etc., it becomes insufficiently rigid. For example, Patent Literature 1 discloses a technique to address insufficient rigidity of a wiring board. This technique is employed in a wiring board having a reinforced portion, which is formed by making an extended portion of a flexible substrate and folding the extended portion.

In this technique, however, a part of the extended portion is folded over to a conductive pattern thereon which is eventually disconnected. Since this technique uses a flexible substrate, the cost for manufacturing a wiring board is high. A reinforced portion can be provided on the wiring board using a rigid substrate instead of a flexible substrate so as to increase the thickness of some parts of the wiring board. However, for example, when the wiring board is dropped, an impact arising therefrom is transmitted to the wiring board, and wires connecting electronic components are eventually disconnected.

In the meantime, with the advance of compact and thin electronic devices, to allow multiple three-dimensional mountings on a wiring board to be placed in a limited space, a wiring board having built-up layers in a partial section has been developed.

However, during a step to form built-up layers in a partial section of a wiring board, the build-up resin for forming built-up resin layers may occasionally overflow. Thus, Patent Literature 2 discloses a wiring board using framed built-up resin films where the periphery of the built-up resins is surrounded by a framing member.

Even if the technique disclosed in Patent Literature 2 is employed, wires connecting electronic components are eventually disconnected when the wiring board receives an impact such as from being dropped or the like and the impact reaches the wiring board.
Patent Literature 1: Unexamined Japanese Patent Application KOKAI Publication No. H5-152693
Patent Literature 2: Unexamined Japanese Patent Application KOKAI Publication No. 2006-32830

### Disclosure of the Invention

### Problem to be Solved by the Invention

The present invention is to solve the above subject matter; namely, to provide a wiring board and its manufacturing method where the risk of rupture in the wiring that connects electronic components mounted on a wiring board is minimized when the wiring board receives an impact such as from being dropped or the like.

### Means for Solving the Problem

To achieve the above objective, a wiring board according to the first aspect of the present invention is structured by laminating a first substrate, a second substrate having a smaller mounting area than that of the first substrate, and a base substrate positioned between the first substrate and the second substrate. At least a portion of the periphery is formed thinner than the central portion. The base substrate is formed with resin containing inorganic filler, and the first substrate and the second substrate are formed with pliable resin.

Also, to achieve the above objective, a wiring board according to the second aspect of the present invention is structured by laminating a first substrate, a second substrate having a smaller mounting area than that of the first substrate, and a base substrate positioned between the first substrate and the second substrate. At least a portion of the periphery is formed thinner than the central portion, and the base substrate is formed with pliable resin. The first substrate is formed with at least either resin containing inorganic filler or base material of resin-impregnated inorganic fabric, and the second substrate is formed with at least either resin containing inorganic filler or base material of resin-impregnated inorganic fabric.

Also, to achieve the above objective, a method of manufacturing a wiring board according to the third aspect of the present invention has a base-substrate forming step to form a base substrate; an insulation-layer forming step to form insulation layers positioned on both surfaces of the base substrate; and a cutting step, by cutting the insulation layers, to form a first substrate and a second substrate that has a smaller mounting area than that of the first substrate, while forming at least a portion of the periphery to be thinner than the central portion. And, the base substrate is formed with resin containing inorganic filler, and the first substrate and second substrate are formed with a pliable resin.

Furthermore, to achieve the above objective, a method of manufacturing a wiring board according to the fourth aspect of the present invention has a base-substrate forming step to form a base substrate; an insulation-layer forming step to form insulation layers positioned on both surfaces of the base substrate; and a cutting step, by cutting the insulation layers, to form a first substrate and a second substrate that has a smaller mounting area than that of the first substrate, while forming at least a portion of the periphery to be thinner than the central portion. And, the base substrate is formed with a pliable resin, the first substrate is formed with at least either resin containing inorganic filler or base material of resin-impregnated inorganic fabric, and the second substrate is formed with at least either resin containing inorganic filler or base material of resin-impregnated inorganic fabric.

### Effect of the Invention

When a wiring board according to the present invention is, e.g., dropped and is subject to an impact induced thereby, wires connecting electronic components mounted on the wiring board are not easily disconnected.

### Brief Description of Drawings

Fig. 1A is a side view illustrating a wiring board according to an embodiment of the present invention.
Fig. 1B is a plan view illustrating a wiring board according to an embodiment of the present invention.
Fig. 2 is a cross-sectional view illustrating a wiring board according to an embodiment of the present invention.
Fig. 3 is a cross-sectional view illustrating a wiring board according to an embodiment of the present invention.
Fig. 4 is a cross-sectional view illustrating a wiring board according to an embodiment of the present invention.
Fig. 5 is a cross-sectional view illustrating a wiring board according to an embodiment of the present invention.
Fig. 6 is a cross-sectional view illustrating a wiring board according to an embodiment of the present invention.
Fig. 7A illustrates a step of a method to manufacture a wiring board according to an embodiment of the present invention.
Fig. 7B illustrates a step of a method to manufacture a wiring board according to an embodiment of the present invention.
Fig. 7C illustrates a step of a method to manufacture a wiring board according to an embodiment of the present invention.
Fig. 7D illustrates a step of a method to manufacture a wiring board according to an embodiment of the present invention.
Fig. 7E illustrates a step of a method to manufacture a wiring board according to an embodiment of the present invention.
Fig. 7F illustrates a step of a method to manufacture a wiring board according to an embodiment of the present invention.
Fig. 7G illustrates a step of a method to manufacture a wiring board according to an embodiment of the present invention.
Fig. 7H illustrates a step of a method to manufacture a wiring board according to an embodiment of the present invention.
Fig. 7I illustrates a step of a method to manufacture a wiring board according to an embodiment of the present invention.
Fig. 7J illustrates a step of a method to manufacture a wiring board according to an embodiment of the present invention.
Fig. 7K illustrates a step of a method to manufacture a wiring board according to an embodiment of the present invention.
Fig. 7L illustrates a step of a method to manufacture a wiring board according to an embodiment of the present invention.
Fig. 7M illustrates a step of a method to manufacture a wiring board according to an embodiment of the present invention.
Fig. 7N illustrates a step of a method to manufacture a wiring board according to an embodiment of the present invention.
Fig. 7O illustrates a step of a method to manufacture a wiring board according to an embodiment of the present invention.
Fig. 7P illustrates a step of a method to manufacture a wiring board according to an embodiment of the present invention.
Fig. 7Q illustrates a step of a method to manufacture a wiring board according to an embodiment of the present invention.
Fig. 7R illustrates a step of a method to manufacture a wiring board according to an embodiment of the present invention.
Fig. 7S illustrates a step of a method to manufacture a wiring board according to an embodiment of the present invention.
Fig. 7T is a view illustrating wiring boards according to an embodiment of the present invention.
Fig. 8 is a cross-sectional view of a wiring board according to an embodiment of the present invention.
Fig. 9 is a cross-sectional view of a wiring board according to an embodiment of the present invention.
Fig 10 is a cross-sectional view of a wiring board according to an embodiment of the present invention.
Fig. 11A illustrates a step of a method to manufacture a wiring board according to an embodiment of the present invention.
Fig. 11B illustrates a step of a method to manufacture a wiring board according to an embodiment of the present invention.
Fig. 12A is a cross-sectional view of a wiring board according to an embodiment of the present invention.
Fig. 12B is a cross-sectional view of a wiring board according to an embodiment of the present invention.

### Explanation of Reference Numerals

- 1: first substrate
- 2: second substrate
- 3: base substrate
- 5: opening
- 7: keypad
- 8: electronic chip
- 9: solder
- 10: gold pad
- 11: interlayer groove section
- 12: adhesion prevention layer
- 13: multi-layer section
- 14: fewer-layer section
- 19: wiring board according to the present invention
- 44: via
- 51: copper foil
- 52: dummy core
- 54: copper foil
- 55: core material
- 61: copper foil
- 62: prepreg
- 63: through-hole
- 71: copper foil
- 72: epoxy resin
- 81: epoxy resin
- 82: copper foil
- 83: solder-resist
- 91: gold plating
- 92: electronic component

### Best Mode for Carrying Out the Invention

### (FIRST EMBODIMENT OF A WIRING BOARD ACCORDING TO A SPECIFIC EXAMPLE OF THE PRESENT INVENTION)

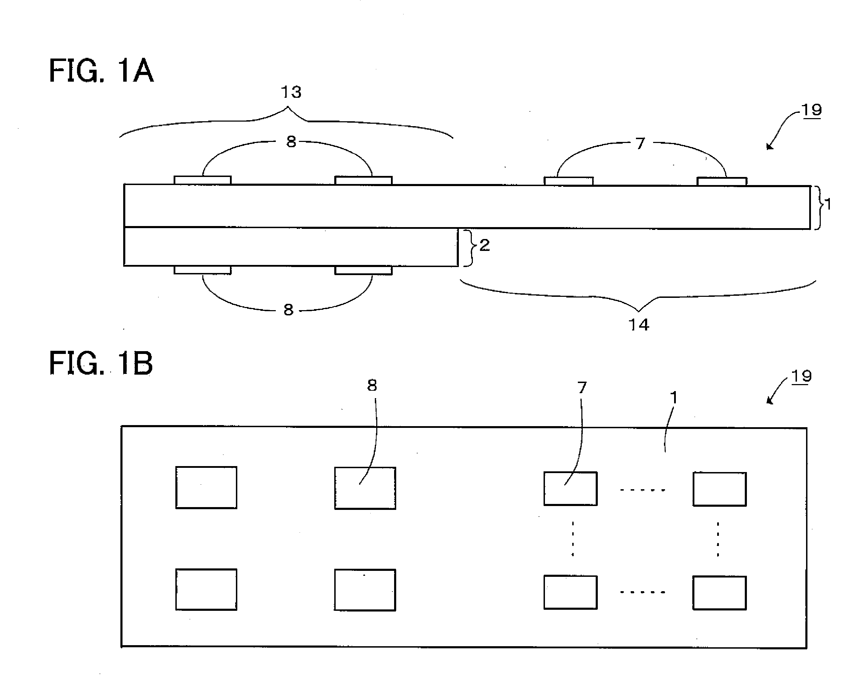

In the following, an embodiment of a wiring board according to a specific example of the present invention is described with reference to the drawings.
As shown in Fig. 1A, wiring board 19 according to a specific example of the present invention has a different thickness on one edge from that on the other edge. The number of layers in the section having a different thickness differs from the number of layers in the thinner section. Namely, wiring board 19 has thick multi-layer section 13 and relatively thin fewer-layer section 14. Multi-layer section 13 is formed by laminating two layers; first substrate 1 and second substrate 2. Fewer-layer section 14 has first substrate 1, which is extended from multi-layer section 13.

As shown in Figs. 1A and 1B, first substrate 1 and second substrate 2 have the same width and different lengths, and one end of first substrate 1 and one end of second substrate 2 are aligned. The thickness of first substrate 1 is made less than that of the central portion, which is the total thickness of first substrate 1, base substrate 3 and second substrate 2. Likewise, the thickness of second substrate 2 is made less than that of the central portion, and the thickness of base substrate 3 is made less than that of the central portion. First substrate 1 and second substrate 2 are each formed with pliable base material mainly containing epoxy resin.

On the surfaces (mounting surfaces) of first substrate 1 and second substrate 2, connection pads to connect electronic components are formed; on the surfaces (mounting surfaces) and inner surfaces of first substrate 1 and second substrate 2, wiring patterns to structure electrical circuits are formed.

On the mounting surfaces of first substrate 1 and second substrate 2, electronic components 7, 8 are arranged and connected to connection pads according to their requirements. Electronic components 7, 8 are connected with each other through connection pads and wiring patterns.

Wiring board 19 is placed, for example, in the casing of a cell phone device. Under such circumstance, electronic component 7 positioned in fewer-layer section 14 is structured, for example, with the keypad of a keyboard; and electronic component 8 positioned in multi-layer section 13 is structured with an electronic chip, IC module, functional components and others. Also, in the step portion formed by multi-layer section 13 and fewer-layer section 14, for example, a thin-type battery is placed.

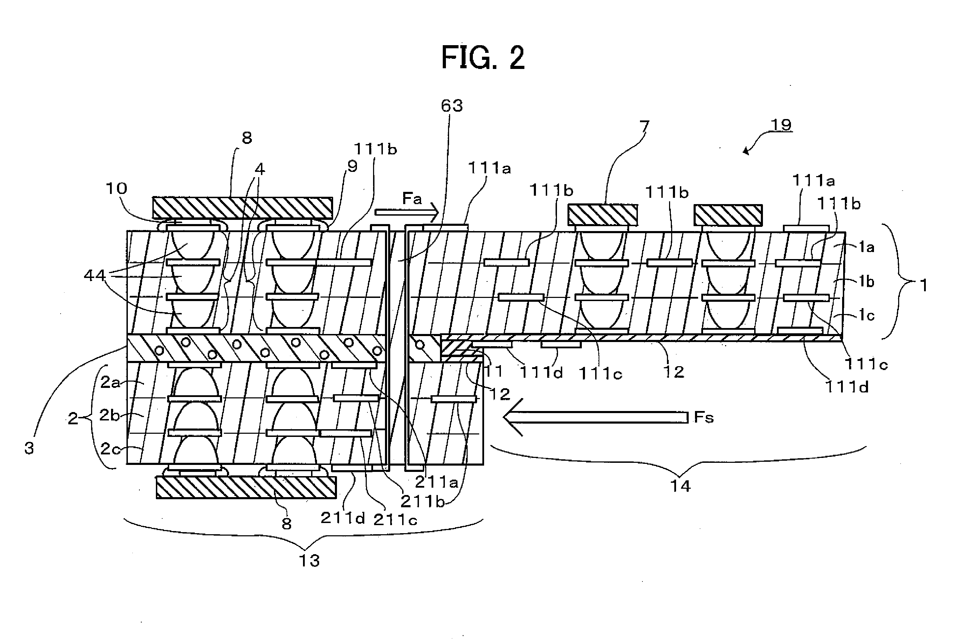

Next, a detailed structure of wiring board 19 having the above overall structure is described in reference to Fig. 2. As illustrated, first substrate 1 and second substrate 2 are laminated with base substrate 3 in between. One end (the left end as illustrated in the drawing) of base substrate 3 is made to be flush with first substrate 1 and second substrate 2. Base substrate 3 is made of resin containing inorganic filler. The resin containing inorganic filler is prepared by combining silica filler with glass-epoxy resin. For silica filler, fused silica (SiO₂) is used. Base substrate 3 is made 50-100 µm, preferably about 100 µm.

Base substrate 3 is formed to be shorter than second substrate 2, and between first substrate 1 and second substrate 2, groove (hereinafter referred to as "interlayer groove section") 11 is formed. Interlayer groove section 11 is an aperture. The groove may be filled with elastic material or viscous material such as silicone gel or silicone oil. When wiring board 19 receives an impact from being dropped, the groove aperture or silicone gel or silicone oil that is filled in the interior of the groove cushions the impact as a shock-absorbing layer. Therefore, by being structured in this way, tolerance to impact from being dropped may be improved.

First substrate 1 has a structure of laminated multiple insulation layers (1a, 1b, 1c). Each insulation layer is made of epoxy resin or the like with a thickness approximately 10 µm-60 µm. On the upper surface of insulation layer (1a), between epoxy-resin layers (1a) and (1b), between insulation layers (1b) and (1c) and on the lower surface of insulation layer (1c), wiring patterns (111a, 111b, 111c, 111d) are formed respectively. Each wiring pattern (111a, 111b, 111c, 111d) electrically connects required portions inside the circuit substrate.

Second substrate 2 also has a structure of laminated multiple insulation layers (2a, 2b, 2c) made of epoxy resin or the like with a thickness approximately 10 µm - 60 µm. On the lower surface of insulation layer (2a), between epoxy-resin layers (2a) and (2b), between insulation layers (2b) and (2c) and on the upper surface of insulation layer (2c), wiring patterns (211 a, 211b, 211 c, 211 d) are formed respectively. Each wiring pattern (211 a, 211b, 211c, 211d) electrically connects required portions inside the circuit substrate.

On the exposed portion of the lower surface of first substrate 1 and the exposed portion of the upper surface of the second substrate, adhesion prevention layers 12 as a protective insulation layer are formed. At the step portion created when laminating first substrate 1 and second substrate 2, conductive pattern (111d) is formed. Also, to the right of conductive pattern (111d) formed at the step portion, conductive pattern (111d) is formed as well.

Keypad 7 is arranged on the conductive pattern formed on the surface of fewer-layer section 14. Further, using solder 9, electronic chip 8 is anchored and connected to wiring patterns and built-up vias 4 through connection pads 10. For solder 9, Sn/Ag/Cu was used.

Moreover, through-hole 63 is formed, penetrating base substrate 3, further penetrating first substrate 1 and second substrate 2, and connecting wiring pattern (111a) and wiring pattern (211d) of second substrate 2. The inner surface of through-hole 63 is plated so as to electrically connect wiring patterns. The area enveloped by plated through-hole 63 may be filled with resin such as epoxy-resin.

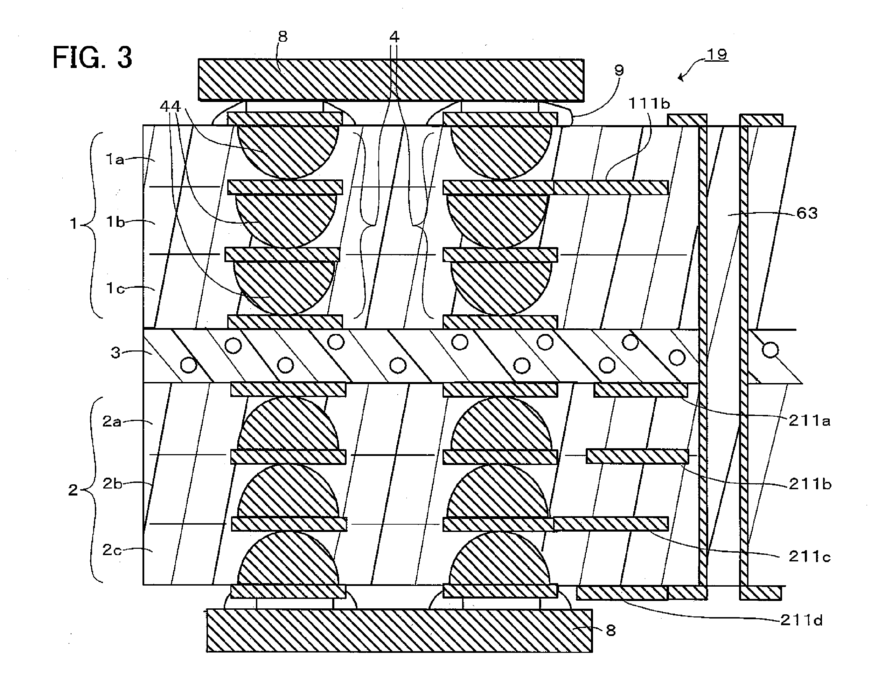

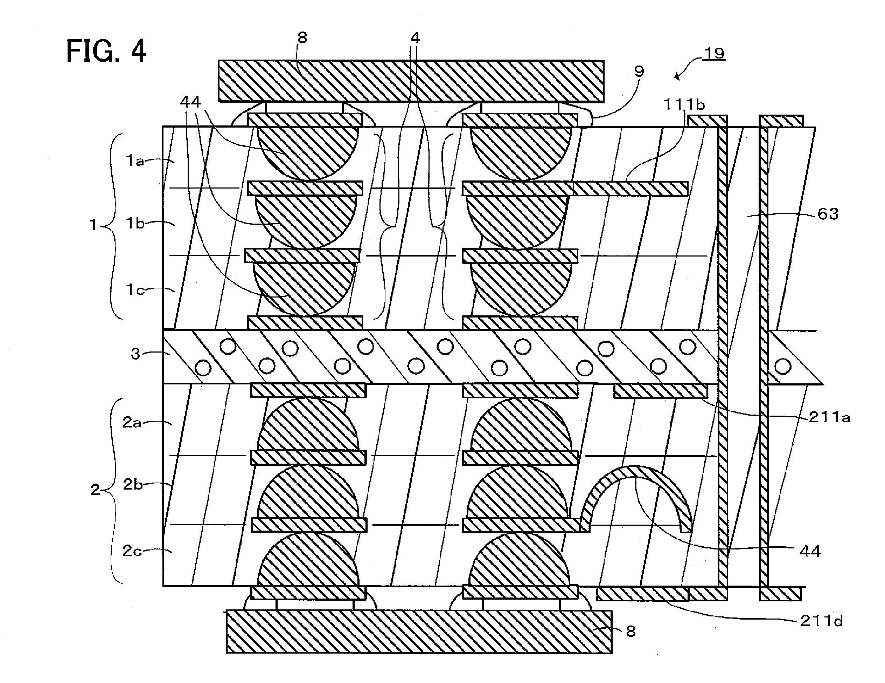

In first substrate 1 and second substrate 2, multiple built-up vias 4 are formed. Built-up vias 4 are structured by stacking vias 44 formed in each insulation layer (1a-1c, 2a-2c). Built-up vias 4 connect required portions of wiring patterns (111a-111d) and also connect required portions of wiring patterns (211a-211d). On the inner surface of each via 44 forming built-up via 4, a conductive layer made of copper plating or the like is formed. As shown in Fig. 3, the interior of each via 44 is filled with conductor such as copper. However, as shown in Fig. 4, the interior of via 44 may be filled with resin such as epoxy-resin.

Wiring board 19 having the above structure, for example, transmits operational signals from keypad 7 to an IC chip through built-up vias 4, wiring patterns (111a-111d) and through-hole 63, and the signals are then processed at the IC chip. By doing so, varieties of signal processing may be conducted.

Also, as described above, wiring board 19 is structured with multi-layer section 13 and fewer-layer section 14 and has a step portion. And at the lower portion of fewer-layer section 14, a large-volume component such as a cell-phone battery may be placed.

Since base substrate 3 is made of glass-epoxy resin containing silica filler, it is highly rigid. Therefore, multi-layer section 13, because of base substrate 3 placed there, is highly rigid compared with fewer-layer section 14. On the other hand, fewer-layer section 14 is relatively flexible compared with multi-layer section 13. Thus, it is possible to place electronic components according to the reliability level they require when being placed.

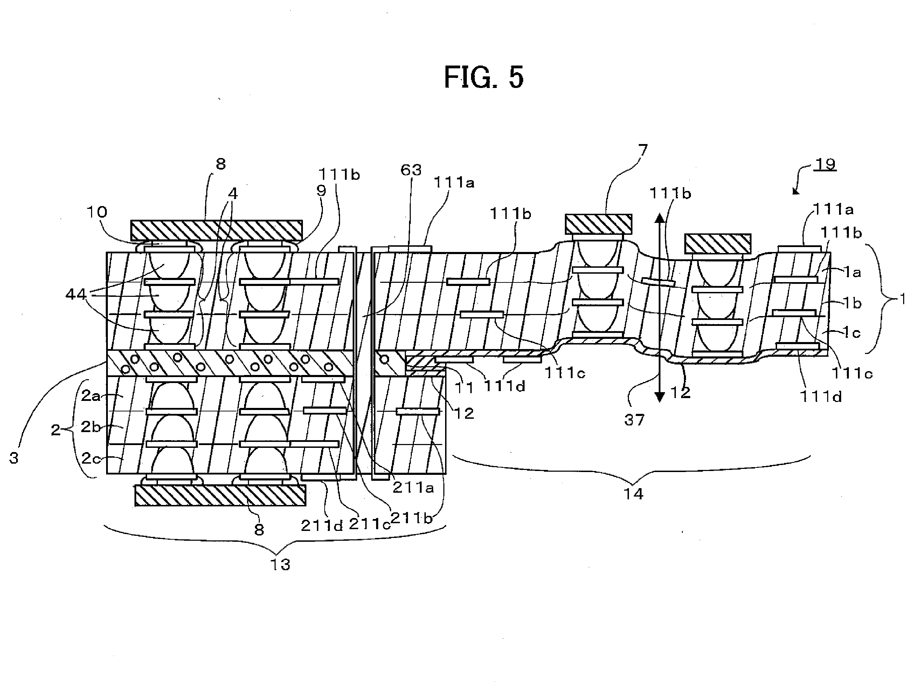

Also, for example, when the electronic device is dropped and an impact or the like is exerted on wiring board 19, due to the relative flexibility of fewer-layer section 14 compared with multi-layer section 13, fewer-layer section 14 vibrates as shown by arrow 37 in Fig. 5. Since portions of fewer-layer section 14 vibrate, the impact from being dropped or the like is converted to vibration motion energy, and the impact is absorbed accordingly. As a result, the risk of rupture in the wiring that connects the electronic components mounted on wiring board 19 may be minimized.

Furthermore, since first insulation layer 1 and second insulation layer 2 are formed with pliable resin, when an impact is exerted on the wiring board, first insulation layer 1 and second insulation layer 2 absorb the impact as shock-absorbing layers.

Also, built-up vias 4 are formed as a stacked via made by laminating multiple vias 44. By making such a stacked interlayer connection structure, the wiring length is shortened, and thus preferable for mounting electronic components requiring large amounts of electricity.

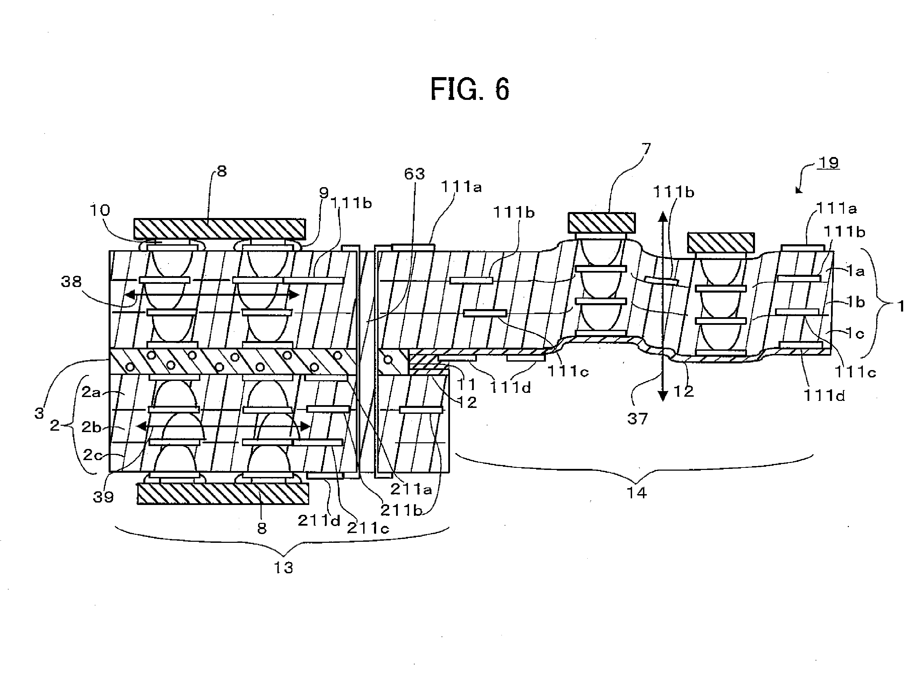

Moreover, built-up vias 4 have a certain degree of mobility. Therefore, for example, when the electronic device is dropped and an impact is exerted on wiring board 19, the impact may be absorbed at built-up vias 4 through the movement of built-up vias 4 as shown by arrows 38, 39 in Fig. 6. As a result, the risk of rupture in the wiring that connects the electronic components mounted on wiring board 19 may be minimized. In addition, through-hole 63, which penetrates base substrate 3, is formed, and the inner surface of through-hole 63 is plated (or filled with resin). Thus, if shearing force (Fs) is exerted on the wiring board from a horizontal direction, through-hole 63 may counter the shearing force, thus preventing first substrate 1 and second substrate 2 from sliding.

In addition, if solid material or the like is filled in interlayer groove section 11, when the impact from being dropped is exerted on the wiring board, interlayer groove section 11 cushions the impact as a shock-absorbing layer. Accordingly, when interlayer groove section 11 is formed, by improving tolerance to impact from being dropped, the risk of rupture in the wiring that connects the electronic components mounted on the wiring board may be minimized.

Also, in certain circumstances, two wiring boards of the present invention may be combined and sold in such a way that each fewer-layer section 14 is closely placed. Here, if a wiring pattern is formed at the step portion created when first substrate 1 and second substrate 2 are laminated, in a circumstance when a user or the like uses the combined wiring boards of the present invention separately, warping of the wiring boards may be prevented. Namely, multi-layer section 13, because of base substrate 3 positioned there, is rigid compared with fewer-layer section 14. Thus, when a user or the like uses the combined wiring boards of the present invention separately, warping does not occur at multi-layer section 13. On the other hand, fewer-layer section 14 is flexible compared with multi-layer section 13. Thus, when a user or the like uses the combined wiring boards of the present invention separately, warping could possibly occur at fewer-layer section 14, especially at the step portion of fewer-layer section 14 created when first substrate 1 and second substrate 2 are laminated. However, if a wiring pattern is formed at the step portion, in a circumstance when a user or the like uses the combined wiring boards of the present invention separately, warping may be prevented.

### (METHOD OF MANUFACTURING A WIRING BOARD ACCORDING TO A SPECIFIC EXAMPLE OF THE PRESENT INVENTION)

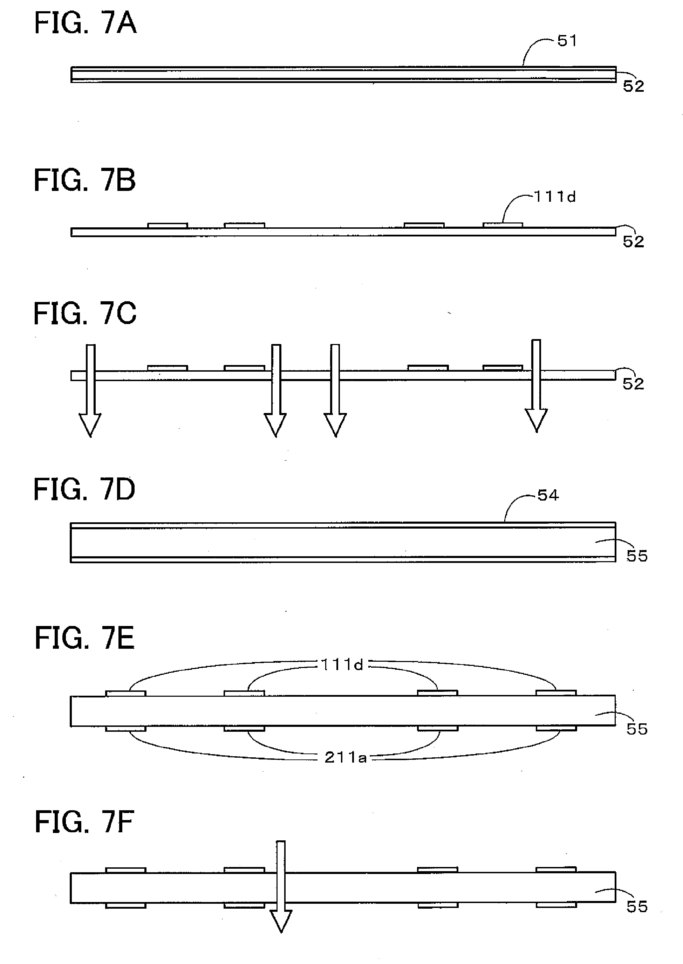

In the following, a method of manufacturing wiring board 19 according to the present invention is described.
First, as shown in Fig. 7A, dummy core 52, which will form adhesion prevention layer 12, is prepared. Dummy core 52 is made, for example, of a C-stage epoxy-resin. On dummy core 52, copper foil 51 is deposited.

Next, as shown in Fig. 7B, by patterning copper foil 51, conductive pattern (111d) is formed at a predetermined position.

Next, as shown by arrows in Fig. 7C, dummy core 52 is cut by a laser or the like to adjust its length to a length preferred for use in wiring board 19.

Meanwhile, as shown in Fig. 7D, core 55, which functions as base substrate 3, is prepared. Core 55 is made, for example, of highly rigid material such as glass-epoxy resin containing inorganic filler such as glass filler or silica filler. On both surfaces of core 55, copper foil 54 is deposited.

Next, as shown in Fig. 7E, by patterning copper foil 54, conductive patterns (111d, 211a) are formed to structure wiring patterns.

Next, as shown by an arrow in Fig. 7F, in core 55 using a laser or the like, a hole to insert dummy core 52 is formed.

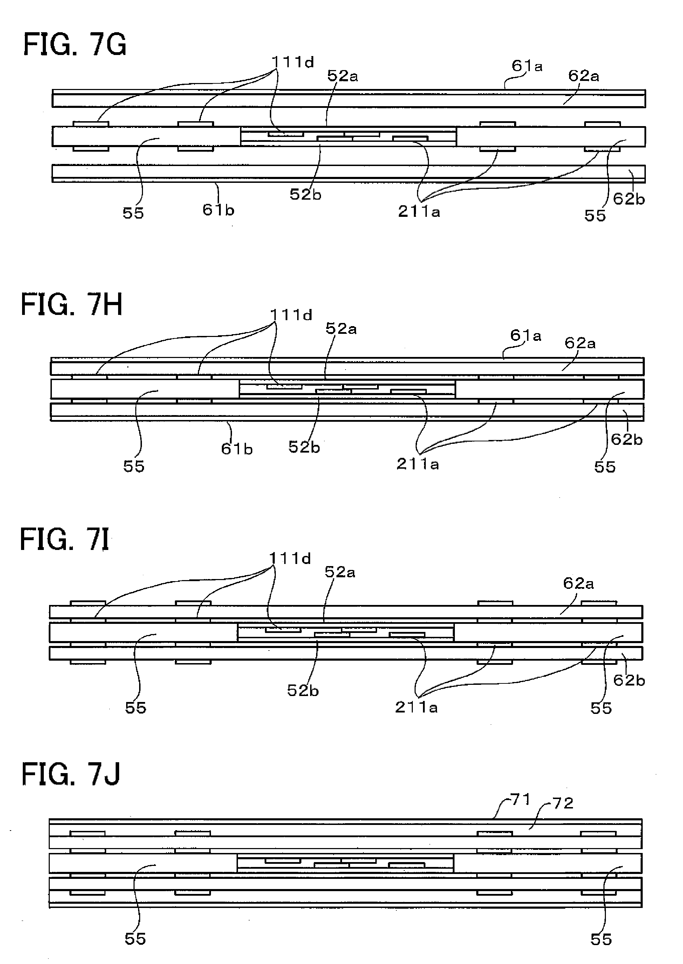

Next, as shown in Fig. 7G, cut-out dummy cores (52a, 52b) are placed in such a way that conductive pattern (111d) and conductive pattern (211 a) are laminated facing inward. Then, laminated dummy cores (52a, 52b) and cut core 55 are horizontally connected. Then, on the top and bottom of dummy cores (52a, 52b) and core 55, prepreg (62a, 62b) are laminated. For prepreg (62a, 62b), low-flow prepreg impregnated with low-flow epoxy-resin is preferred. In the following, on the surfaces of prepreg (62a, 62b), copper foils (61 a, 61b) are deposited.

Next, as shown in Fig. 7H, on the laminate shown in Fig. 7G, pressure is applied. Pressure is, for example, applied by hydraulic power using hydraulic pressing equipment under conditions calling for temperature of 200°C, pressure of 40 kgf and pressing time of three (3) hours. By doing so, resin is squeezed out from the prepreg, and the prepreg and core material will be integrated accordingly. At this time, since dummy core 52 is made of a C-stage epoxy-resin, the materials in dummy core 52 are not integrated with each other. For applying pressure, vacuum pressing may be employed instead of hydraulic pressing. By conducting vacuum pressing, bubbles may be kept from mixing into the resin which forms the insulation layers. Vacuum pressing is conducted, for example, for an hour. Peak heating temperature is set, for example, at 175°C; and vacuum-pressing pressure is set, for example, at 3.90 x 10⁶ [Pa].

Next, as shown in Fig. 7I, by removing the unnecessary portions of copper foil 61 from the laminate shown in Fig. 7H, wiring patterns are formed.

Next, as shown in Fig. 7J, epoxy resin 72 is further laminated to form inner layers. On both surfaces of epoxy resin 72, copper foil 71 is formed. Then, pressure is applied. Pressure may be applied, for example, by hydraulic power using hydraulic pressing equipment, or by vacuum pressing.

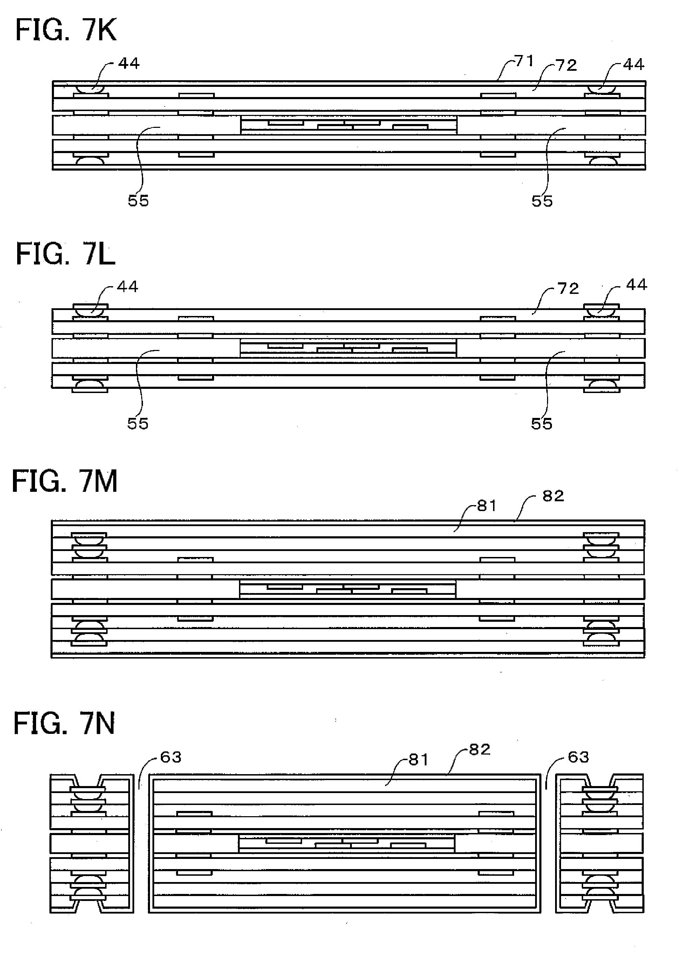

Then, as shown in Fig. 7K, vias 44 are formed. Namely, in epoxy resin 72 made of insulation resin, openings for via-holes are formed. Those openings may be formed by beaming a laser. Then, to remove resin residue remaining on the side and bottom surfaces of the openings formed by beaming a laser, a desmear treatment is performed. The desmear treatment is performed using an oxygen plasma discharge treatment, a corona discharge treatment, an ultra-violet laser treatment or an exima laser treatment. In the openings formed by beaming a laser, conductive material is filled to form filled via holes. As for conductive material, conductive paste or metal plating formed by an electrolytic plating process is preferred. For example, vias 44 are filled with conductor such as copper plating. To reduce the manufacturing cost and improve productivity by simplifying the filled-via forming step, filling with a conductive paste is preferred. For example, a conductive paste (such as thermo-set resin containing conductive particles) may be printed by screen-printing, filled in vias 44 and cured. By filling the interiors of vias 44 with the same conductive paste material, connection reliability when thermo-stress is exerted on vias 44 may be improved. On the other hand, regarding connection reliability, metal plating formed by an electrolytic plating process is preferred. Especially, electrolytic copper plating is preferred.

Then, as shown in Fig. 7L, by removing the unnecessary portions of copper foil 71, inner-layer patterns are formed.

Next, as shown in Fig. 7M, after inner layers and vias are further formed, epoxy-resin 81 is laminated to form outer layers. On both surfaces of epoxy-resin 81, copper foil 82 is deposited. Here, a copper foil sheet containing resin (Resin Cupper Film: RCF) may be deposited and pressed.

Next, as shown in Fig. 7N, vias are formed in the RCF. Further, in the laminated layers shown in Fig. 7M, holes are bored by a drill. The holes penetrate the base substrate and insulation layers formed on both sides of the base substrate. By doing so, through-holes 63 are formed. Then, using copper plating or the like, the interiors of the vias and through-holes 63 are filled with conductor. Also, according to requirements, by patterning the surface copper foil, conductive patterns are formed.

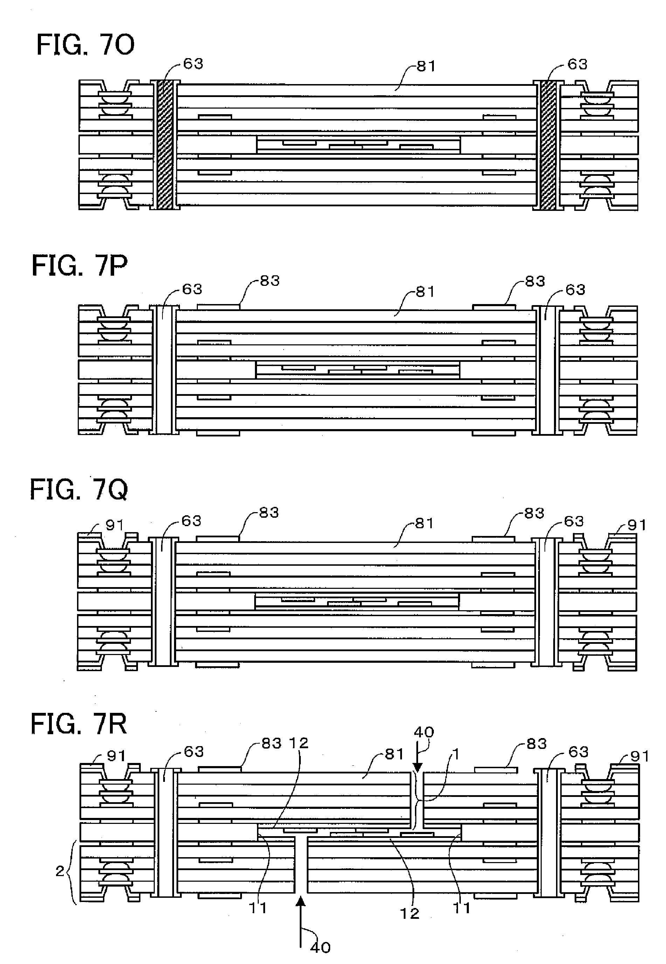

Next, as shown in Fig. 7O, the interiors of through-holes 63 are filled with epoxy resin, and by removing unnecessary portions of copper foil 82, outer-layer patterns are formed.

Next, as shown in Fig. 7P, solder resist 83 is formed. Here, the solder resist indicates heat-resistant coating material, which is used when applying solder to cover the portions to keep the solder from adhering. For solder-resist varieties, photo-setting-type solder resist and thermo-setting-type solder resist may be used. For a coating method, a screen-printing method or curtain-coating method may be used.

Next, as shown in Fig. 7Q, to protect outer-layer patterns, gold plating 91 is performed by chemical plating. Other than chemical plating, methods such as fusion plating and electrical plating may be used. Moreover, other than gold plating, alloy plating may be used.

Next, as shown by arrows 40 in Fig. 7R, laser beams from laser processing equipment, for example CO₂ laser, are beamed using conductive patterns (111d) as a stopper to cut insulation layers and the copper foil sheet containing resin (RCF). Here, the thickness of conductive patterns (111d) is preferred to be made approximately 5-10 µm: If too thin, laser beams penetrate the pattern; and if too thick, conductive circuit patterns with a fine line width are difficult to form. Meanwhile, by laser cutting as shown in Fig. 7R, interlayer groove sections 11 are also formed. Namely, by laser cutting, using adhesion prevention layer 12 formed on first substrate 1 and adhesion prevention layer 12 formed on second substrate 2 as groove side-walls, and one surface of base substrate 3 as the groove bottom surface, interlayer groove sections 11 are formed.

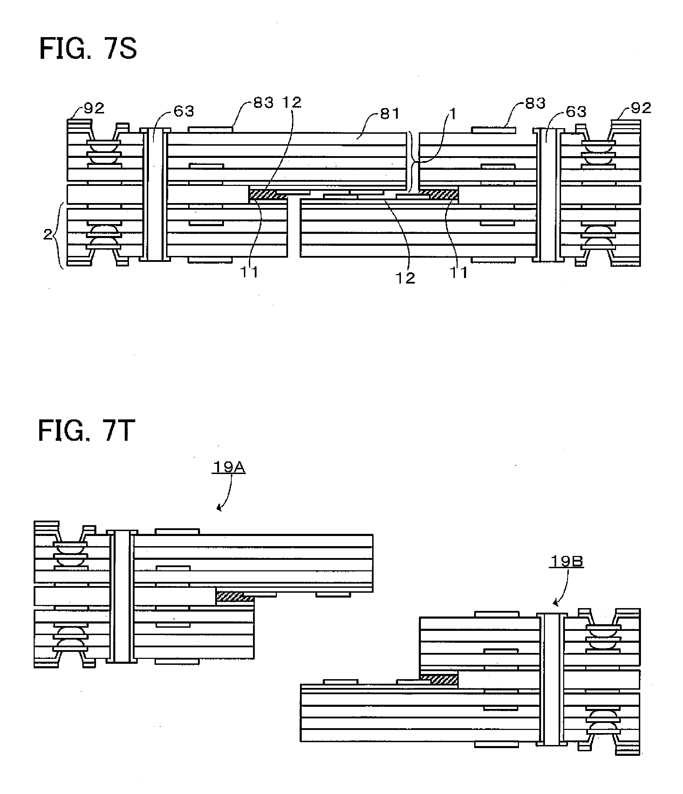

Lastly, as shown in Fig. 7S, electronic components 92 are mounted. Electronic components 92 are electronic chip 8 and keypad 7. And, interlayer groove sections 11 may be filled with elastic material, viscous material or the like.

Then, as shown in Fig. 7T, wiring board (19A) and wiring board (19B) are used separately. In such a circumstance, since adhesion prevention layers 12 are formed, wiring board (19A) and wiring board (19B) may be separated by a simple process to be used separately. Regarding a wiring board according to the present invention, when an electronic device such as a cell phone receives an impact from being dropped or the like, connection breakage of electronic components or the like mounted in the wiring board may be prevented. In addition, when being shipped to a user, the wiring board can be handled compactly, and when being used by the user, the combined wiring boards can be separated easily.

### (SECOND EMBODIMENT OF A WIRING BOARD ACCORDING TO A SPECIFIC EXAMPLE OF THE PRESENT INVENTION)

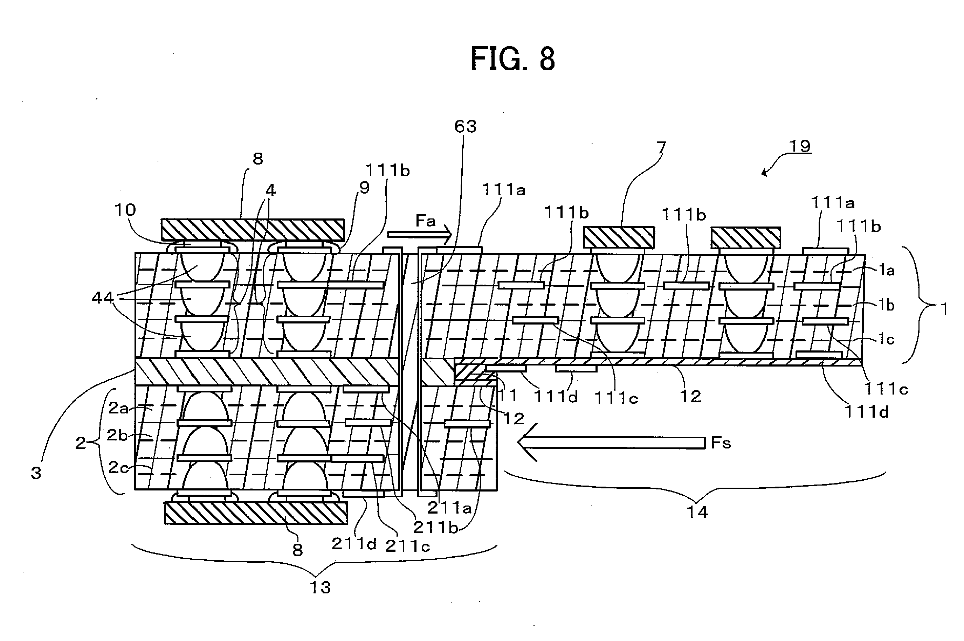

In the First Embodiment of the present invention, base substrate 3 contains resin containing inorganic filler, and first insulation layer 1 and second insulation layer 2 contain pliable resin. However, according to the Second Embodiment of the present invention, as shown in Fig. 8, base substrate 3 contains pliable resin and first insulation layer 1 and second insulation layer 2 contain base material of resin-impregnated inorganic fabric. The rest of the structure is the same as in the First Embodiment.

The pliable resin forming base substrate 3 contains mainly epoxy resin. The base material of resin-impregnated inorganic fabric forming first insulation layer 1 and second insulation layer 2 is prepared by curing prepreg. The prepreg is prepared by impregnating glass-cloth inorganic fabric with epoxy resin and preliminarily thermosetting the resin to advance the level of curing. Although the resin to be used for the prepreg is preferred to have low-flow characteristics, one with regular-flow characteristics may also be used. Also, prepreg may be prepared by reducing the amount of epoxy resin to be impregnated in glass-cloth inorganic fabric.

Since base substrate 3 is formed with pliable resin, when an impact is exerted on the wiring board, base substrate 3 absorbs the impact as a shock-absorbing layer. Therefore, when an electronic device such as a cell phone receives an impact from being dropped or the like, the risk of rupture in the wiring that connects the electronic components mounted on the wiring board may be minimized.

The manufacturing method of a wiring board according to the Second Embodiment uses base material of resin impregnated inorganic fabric for a resin to be laminated in reference to Figs. 7G, 7J, and 7M. The rest of the manufacturing method is the same as in the First Embodiment.

### (THIRD EMBODIMENT OF A WIRING BOARD ACCORDING TO A SPECIFIC EXAMPLE OF THE PRESENT INVENTION)

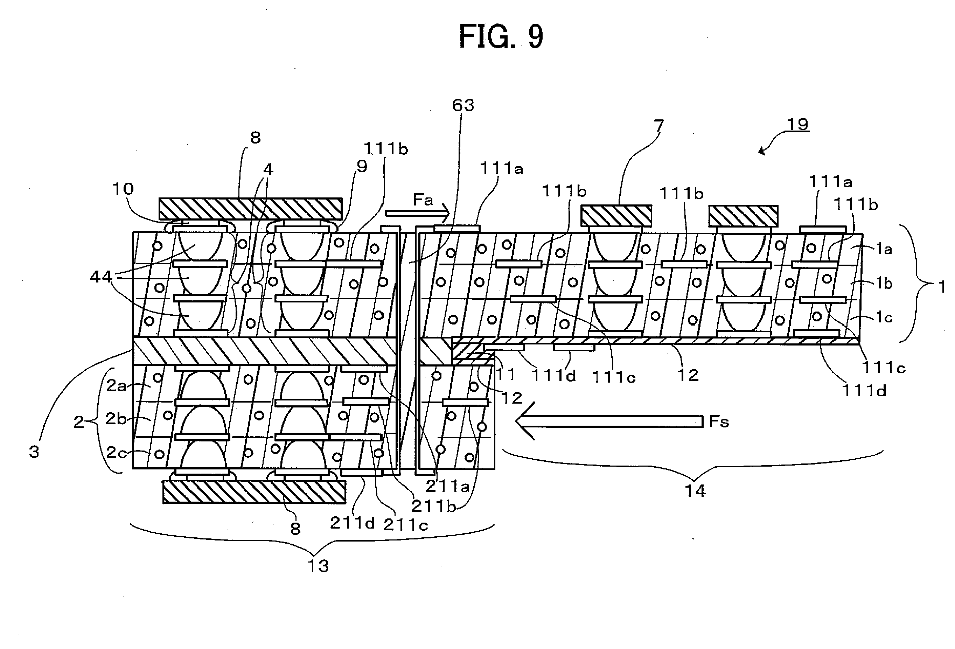

According to the First Embodiment of the present invention, base substrate 3 contains resin containing inorganic filler, and first insulation layer 1 and second insulation layer 2 contain pliable resin. However, according to the Third Embodiment of the present invention, as shown in Fig. 9, base substrate 3 contains pliable resin and first insulation layer 1 and second insulation layer 2 contain resin containing inorganic filler. The rest of the structure is the same as in the First Embodiment.

The pliable resin forming base substrate 3 contains mainly epoxy resin. The resin containing inorganic filler forming first insulation layer 1 and second insulation layer 2 is prepared by combining silica filler with epoxy resin. For the silica filler, fused silica (SiO₂) is used.

Since base substrate 3 is formed with pliable resin, when an impact is exerted on the wiring board, base substrate 3 absorbs the impact as a shock-absorbing layer. Therefore, when an electronic device such as a cell phone receives an impact from being dropped or the like, the risk of rupture in the wiring that connects the electronic components mounted on the wiring board may be prevented.

The manufacturing method of a wiring board according to the Third Embodiment uses resin containing inorganic filler for a resin to be laminated in reference to Figs. 7G, 7J, and 7M. The rest of the manufacturing method is the same as in the First Embodiment.

### (FOURTH EMBODIMENT OF A WIRING BOARD ACCORDING TO A SPECIFIC EXAMPLE OF THE PRESENT INVENTION)

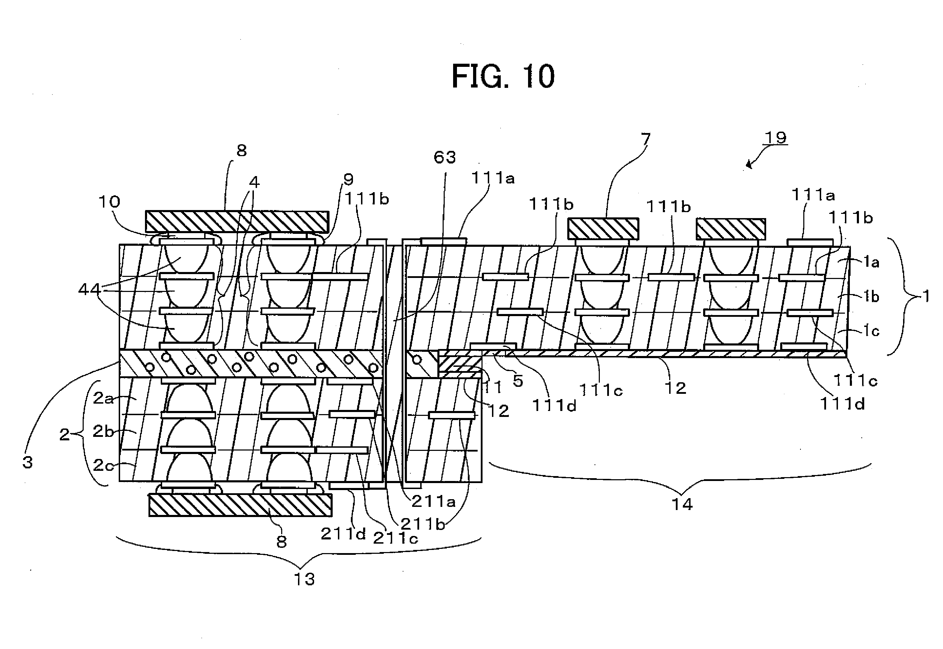

As shown in Fig. 10, in the Fourth Embodiment, at the portion where adhesion prevention layer 12 is made flush with the edge of second substrate 2, opening 5 is formed. The rest of the structure is the same as in the First Embodiment. Under opening 5, part of wiring pattern (111d) is positioned. Inside the groove, which is structured with opening 5 and wiring pattern (111d) placed underneath, is an aperture. The groove may be filled with elastic material or viscous material such as silicone gel or silicone oil. When wiring board 19 receives an impact from being dropped, the aperture inside the groove or silicone gel or silicone oil filled in the groove cushions the impact as a shock-absorbing layer. Therefore, by making such a structure, tolerance to impact from being dropped may be improved.

Also, if solid material or the like is filled in opening 5, the filled solid material or the like may play a role in decreasing warping at the juncture of multi-layer section 13 and fewer-layer section 14 where the number of layers is reduced. Accordingly, at the juncture of multi-layer section 13 and fewer-layer section 14, cracks may be prevented. Furthermore, if opening 5 is filled, for example, with solid material such as resin, the filled solid material plays a role in protecting conductive pattern (111d) mounted on first substrate 1. Therefore, tolerance to corrosion on conductive pattern (111d) may be improved.

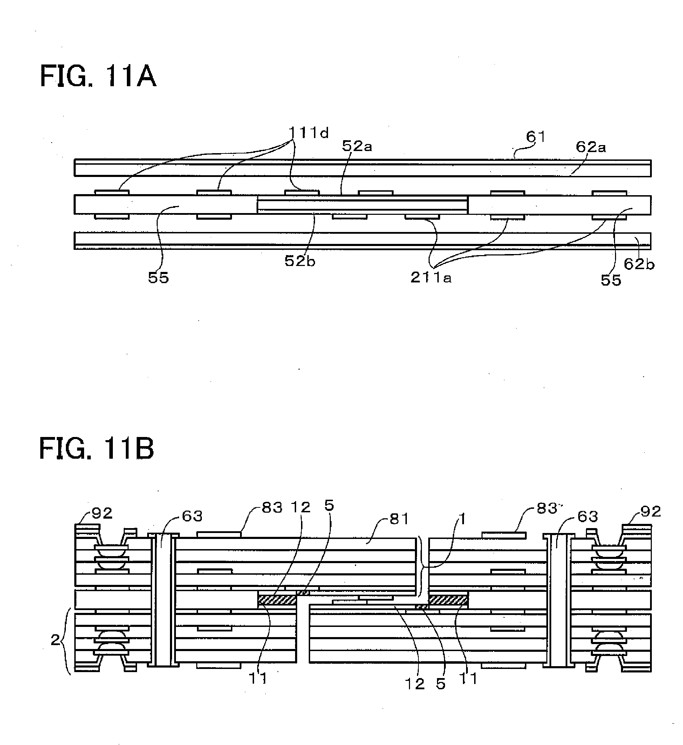

A method of manufacturing a wiring board according to the Second Embodiment is the same as the method of manufacturing a wiring board according to the First Embodiment in reference to Figs. 7A-7F, Figs. 7H-7R and 7T. Instead of Fig. 7G, as shown in Fig. 11A, cut-out dummy cores (52a, 52b) are placed in a way so that conductive pattern (111d) and conductive pattern (211 a) are laminated facing outward. Moreover, instead of Fig. 7S, as shown in Fig. 11B, opening 5 is filled with viscous material such as silicone oil.

### (OTHER EXAMPLES OF THE PRESENT INVENTION)

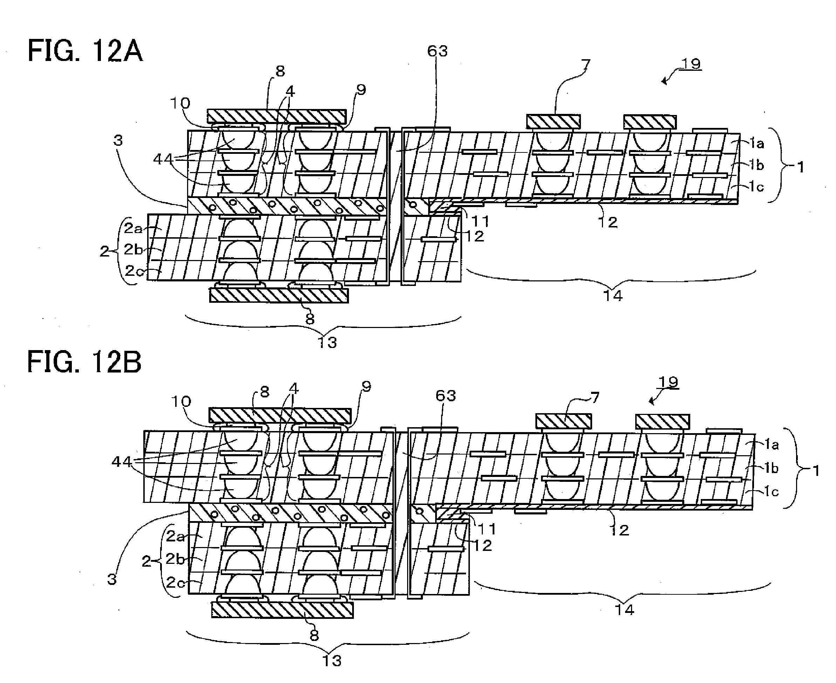

In the above-described embodiments, one end of first substrate 1 and one end of second substrate 2 are aligned. However the present invention is not limited to such embodiments. As shown in Fig. 12A, one end of second substrate 2 may protrude from one end of first substrate 1. Here, the thickness of second substrate 2 is made less than that of the central portion. Similarly, the thickness of first substrate 1 is made less than that of the central portion, and the thickness of base substrate 3 is made less than that of the central portion.

Also, as shown in Fig. 12B, one end of first substrate 1 may protrude from one end of second substrate 2. Here, the thickness of first substrate 1 is less than that of the central portion. Similarly, the thickness of second substrate 2 is less than that of the central portion, and the thickness of base substrate 3 is less than that of the central portion.

In a wiring board according to the First Embodiment of the present invention, first substrate 1 and second substrate 2 are in a layered structure having a rectangular outline. However, they are not limited to such, but may be in a layered structure having a circular, hexagonal or octagonal outline.

Also, in a wiring board according to the First Embodiment of the present invention, base substrate 3 is formed with glass-epoxy resin containing fused silica (SiO₂), but it is not limited to such. As for silica filler, crystalline silica (SiO₂) may also be used, and instead of silica filler, glass filler may possibly be combined. As for glass filler, aluminum oxide (Al₂O₃), magnesium oxide (MgO), boron nitride (BN), or aluminum nitride (AIN) may be used. Also, sodium oxide (Na₂O), potassium oxide (K₂O) boric oxide (B₂O₃), and phosphoric oxide (P₂O₅) may be used in combination thereof. Furthermore, as for inorganic filler, it is not limited to silica filler or glass filler, but inorganic incombustible agents such as antimony trioxide, antimony pentoxide, magnesium hydroxide, aluminum hydroxide, guanidinium salts, zinc borate, molybdic compound, and zinc stannate may be used. Talc, barium sulfate, calcium carbonate, or mica powder may also be used.

Also, in a wiring board according to the First Embodiment, first insulation layer and second insulation layer 2 are made of pliable resin containing mainly epoxy resin. However, pliable resin is not limited to such, but any one of the following resins or a combination thereof may be used: epoxy, polyimide, polycarbonate, polyphenylen ether denaturated, polyphenylen oxide, polybutylene-telephtalate, polyacrylate, polysulfone polyphenylen-sulfid, polyether-etherketone, tetrafluoroethylene, bismaleimide, polysulfone, polyethersulfone, polyphenylsulfone, polyphthalamide, polyamide-imide, polyketone, polyacetale. As for epoxy resin, the following may be used: naphthalene-type epoxy resin, dicyclo-pentadiene-type epoxy resin, biphenyl-type epoxy resin, bisphenole A-type epoxy resin, bisphenol F-type epoxy resin, bisphenol S-type epoxy resin, phenol novolac-type epoxy resin, alkylphenol novolac-type epoxy resin, alalkyl-type epoxy resin, biphenol-type epoxy resin, anthracene-type epoxy resin, epoxydated condensate of phenolic groups and aromatic compound aldehyde containing phenolic hydroxyl groups, triglycidyl isocyanurate and alicyclic epoxy resin.

According to the First Embodiment, as for solder 9, Sn/Ag/Cu was used. However, solder 9 is not limited to such; solder containing antimony, tin, lead, indium or copper may be used. Also, eutectic crystal metals such as Sn/Sb, Sn/Ag, Sn/Pb or Sb/Cu may be used as well. Among such eutectic crystal metals, to avoid having a bad influence on the substrates, using metals having relatively low melting temperatures, 250°C or lower, is preferred.

According to the First Embodiment, interlayer groove section 11 is filled with silicone gel, which is viscous silicone. However, such is not the only example, but interlayer groove section 11 may be filled with solid material. As for solid material to be filled in interlayer groove section 11, high-polymer rubber is preferred as a solid material having viscosity and elasticity. Specifically, butyl rubber, isoprene rubber, butadiene rubber, styrene-butadiene rubber or ethylene-propylene rubber may be used. Moreover, interlayer groove section 11 may be filled with a gas. As the gas to be filled in interlayer groove section 11, a rare gas such as argon, or nitrogen or air may also be used.

Also, according to the Second Embodiment, a prepreg was prepared by impregnating glass-cloth inorganic fabric with epoxy resin and preliminarily thermosetting the resin to advance the level of curing. However, such is not the only example. In addition to epoxy resin, or other than epoxy resin, any one of the following resins or a combination thereof may be used to prepare prepreg: polyimide, polycarbonate, polyphenylen ether denaturated, polyphenylen oxide, polybutylene-telephtalate, polyacrylate, polysulfone polyphenylen-sulfid, polyether-etherketone, tetrafluoroethylene, bismaleimide, polysulfone, polyethersulfone, polyphenylsulfone, polyphthalamide, polyamide-imide, polyketone, polyacetale.

Also, for the inorganic fabric, it is not limited to glass cloth, but fabrics such as alumina fabric, carbon fabric (carbon fiber), silicon carbide fabric, silicon nitride fabric or the like may be used singly or in combination thereof.

According to the Fourth Embodiment, in opening 5, silicone gel, which is viscous silicone, is filled. However, the material to be filled in opening 5 is not limited to such, but solid material may be used. As solid material to be filled in opening 5, high-polymer rubber as a solid material having viscosity and elasticity is preferred. More specifically, butyl rubber, isoprene rubber, butadiene rubber, styrene-butadiene rubber or ethylene-propylene rubber may be used. As the material to be filled in opening 5, a liquid or solid material is preferred, but a gas may be used. In such a case, as the gas to be filled in opening 5, a rare gas such as argon, or nitrogen or air may be used.

In addition, first substrate 1 is not necessarily formed single-layered, but may be formed multi-layered. Namely, first substrate 1 may be structured with a lower-layer insulation layer and an upper-layer insulation layer. Here, a lower-layer insulation layer indicates the insulation layer formed close to base substrate 3; and an upper-layer insulation layer indicates an insulation layer formed on the outer surface of the wiring board. Furthermore, first substrate 1 may be structured with a lower-layer insulation layer, an upper-layer insulation layer and an intermediate insulation layer placed in between. The intermediate insulation layer may be made multi-layered. According to the First Embodiment, the lower-layer insulation layer corresponds to epoxy-resin layer (1c), the intermediate insulation layer corresponds to epoxy-resin layer (1b) and the upper-layer insulation layer corresponds to epoxy-resin layer (1a).

Also, the second substrate is not necessarily formed single-layered, but may be formed multi-layered. Second substrate 2 may also be structured with a lower-layer insulation layer and an upper-layer insulation layer. Furthermore, second substrate 2 may be structured with a lower-layer insulation layer, an upper-layer insulation layer and an intermediate insulation layer placed in between. In the First Embodiment, the lower-layer insulation layer corresponds to epoxy-resin layer (2a), the intermediate insulation layer corresponds to epoxy-resin layer (2b) and the upper-layer insulation layer corresponds to epoxy-resin layer (2c). On top of the upper-layer insulation layer and on top of the lower-layer insulation layer, conductive patterns may be formed. Then, those conductive patterns may be connected with each other through vias 44.

### Industrial Applicability

The present invention may be employed in a wiring board which can mount electronic components, specifically, in a wiring board which can mount electronic components for compact electronic devices.

## Claims

1. A wiring board (19) comprising:
a first substrate (1);
a second substrate (2) having a smaller mounting area than that of the first substrate (1); and
a base substrate (3) laminated between the first substrate (1) and the second substrate (2), wherein
at least a portion of the periphery is formed thinner than the central portion,
the base substrate (3) is formed with resin containing inorganic filler, and
the first substrate (1) and second substrate (2) are formed with pliable resin.

2. A wiring board (19) comprising:
a first substrate (1);
a second substrate (2) having a smaller mounting area than that of the first substrate (1); and
a base substrate (3) laminated between the first substrate (1) and the second substrate (2), wherein
at least a portion of the periphery is formed thinner than the central portion,
the base substrate (3) is formed with pliable resin,
the first substrate (1) is formed with either resin containing inorganic filler or base material of resin-impregnated inorganic fabric, and
second substrate (2) is formed with either resin containing inorganic filler or base material of resin-impregnated inorganic fabric.

3. The wiring board (19) according to Claim 1, wherein vias (44) are formed at least either in the first substrate (1) or the second substrate (2).

4. The wiring board (19) according to Claim 2, wherein vias (44) are formed at least either in the first substrate (1) or the second substrate (2).

5. The wiring board (19) according to Claim 1, wherein an interlayer groove section (11) is formed between the first substrate (1) and the second substrate (2), and in the interlayer groove section (11), at least either gas, liquid or solid material is filled.

6. The wiring board (19) according to Claim 2, wherein an interlayer groove section (11) is formed between the first substrate (1) and the second substrate (2), and in the interlayer groove section (11), at least either gas, liquid or solid material is filled.

7. The wiring board (19) according to Claim 1, wherein a warping prevention portion (111d) is formed at a step portion created when the first substrate (1) and the second substrate (2) are laminated.

8. The wiring board (19) according to Claim 2, wherein a warping prevention portion (111d) is formed at a step portion created when the first substrate (1) and the second substrate (2) are laminated.

9. The wiring board (19) according to Claim 1, wherein an opening (5) is formed at the step portion created when the first substrate (1) and the second substrate (2) are laminated, and in the opening (5), at least either gas, liquid or solid material is filled.

10. The wiring board (19) according to Claim 2, wherein an opening (5) is formed at the step portion created when the first substrate (1) and the second substrate (2) are laminated, and in the opening (5), at least either gas, liquid or solid material is filled.

11. The wiring board (19) according to Claim 1, wherein the inorganic fabric contains glass cloth.

12. The wiring board (19) according to Claim 1, wherein the inorganic filler contains at least either silica filler or glass filler.

13. The wiring board (19) according to Claim 2, wherein the inorganic fabric contains glass-cloth.

14. The wiring board (19) according to Claim 2, wherein the inorganic filler contains at least either silica filler or glass filler.

15. The wiring board (19) according to Claim 1, wherein on the first substrate (1), a conductive pattern is formed; on the second substrate (2), a conductive pattern is formed; and the conductive pattern on the first substrate (1) and the conductive pattern on the second substrate (2) are connected via a through-hole (63).

16. The wiring board (19) according to Claim 2, wherein on the first substrate (1), a conductive pattern is formed; on the second substrate (2), a conductive pattern is formed; and the conductive pattern on the first substrate (1) and the conductive pattern on the second substrate (2) are connected via a through-hole (63).

17. The wiring board (19) according to Claim 3, wherein on the inner surface of the via (44), a conductive layer is formed by plating, and the via (44) is filled with metal.

18. The wiring board (19) according to Claim 4, wherein on the inner surface of the via (44), a conductive layer is formed by plating, and the via (44) is filled with metal.

19. The wiring board (19) according to Claim 3, wherein on the inner surface of the via (44), a conductive layer is formed by plating, and the via (44) is filled with resin.

20. The wiring board (19) according to Claim 4, wherein on the inner surface of the via (44), a conductive layer is formed by plating, and the via (44) is filled with resin.

21. The wiring board (19) according to Claim 1, wherein the first substrate (1) is structured with a lower-layer insulation layer and an upper-layer insulation layer, and the second substrate (2) is structured with a lower-layer insulation layer and an upper-layer insulation layer.

22. The wiring board (19) according to Claim 2, wherein the first substrate (1) is structured with a lower-layer insulation layer and an upper-layer insulation layer, and the second substrate (2) is structured with a lower-layer insulation layer and an upper-layer insulation layer.

23. The wiring board (19) according to Claim 21, wherein on the upper-layer insulation layer, a conductive pattern is formed; on the lower-layer insulation layer, a conductive pattern is formed; and the conductive pattern on the upper-layer insulation layer and the conductive pattern on the lower-layer insulation layer are connected through vias (44).

24. The wiring board (19) according to Claim 22, wherein on the upper-layer insulation layer, a conductive pattern is formed; on the lower-layer insulation layer, a conductive pattern is formed; and the conductive pattern on the upper-layer insulation layer and the conductive pattern on the lower-layer insulation layer are connected through vias (44).

25. A method of manufacturing a wiring board comprising:
a base-substrate forming step to form a base substrate (3);
an insulation-layer forming step to form insulation layers on both surfaces of the base substrate (3); and
a cutting step, by cutting the insulation layer, to form a first substrate (1) and a second substrate (2) having a smaller mounting area than that of the first substrate (1), while forming at least a portion of the periphery to be thinner than the central portion, wherein
the base substrate (3) is formed with resin containing inorganic filler, and
the first substrate (1) and second substrate (2) are formed with pliable resin.

26. A method of manufacturing a wiring board comprising:
a base-substrate forming step to form a base substrate (3);
an insulation-layer forming step to form insulation layers on both surfaces of the base substrate (3); and
a cutting step, by cutting the insulation layer, to form a first substrate (1) and a second substrate (2) having a smaller mounting area than that of the first substrate (1), while forming at least a portion of the periphery to be thinner than the central portion, wherein
the base substrate (3) is formed with pliable resin,
the first substrate (1) is formed with at least either resin containing inorganic filler or base material of resin-impregnated inorganic fabric, and
the second substrate (2) is formed with at least either resin containing inorganic filler or base material of resin-impregnated inorganic fabric.

27. The method of manufacturing a wiring board according to Claim 25, further comprising a via-forming step to form vias (44) in the insulation layers.

28. The method of manufacturing a wiring board according to Claim 26, further comprising a via-forming step to form vias (44) in the insulation layers.

29. The method of manufacturing a wiring board according to Claim 25, further comprising an interlayer groove section forming step to form an interlayer groove section (11) between the first substrate (1) and the second substrate (2), and a filling step to fill at least either gas, liquid or solid material in the interlayer groove section (11).

30. The method of manufacturing a wiring board according to Claim 26, further comprising an interlayer groove section forming step to form an interlayer groove section (11) between the first substrate (1) and the second substrate (2), and a filling step to fill at least either gas, liquid or solid material in the interlayer groove section (11).

31. The method of manufacturing a wiring board according to Claim 25, further comprising a warping prevention section forming step to form a warping prevention portion (111d) at the step portion created when the first substrate (1) and the second substrate (2) are laminated.

32. The method of manufacturing a wiring board according to Claim 26, further comprising a warping prevention section forming step to form a warping prevention portion (111d) at the step portion created when the first substrate (1) and the second substrate (2) are laminated.

33. The method of manufacturing a wiring board according to Claim 25, further comprising an opening forming step to form an opening (5) at the step portion created when the first substrate (1) and the second substrate (2) are laminated, and a filling step to fill at least either gas, liquid or solid material in the opening (5).

34. The method of manufacturing a wiring board according to Claim 26, further comprising an opening forming step to form an opening (5) at the step portion created when the first substrate (1) and the second substrate (2) are laminated, and a filling step to fill at least either gas, liquid or solid material in the opening (5).

35. The method of manufacturing a wiring board according to Claim 25, wherein the inorganic fabric contains glass cloth.

36. The method of manufacturing a wiring board according to Claim 26, wherein the inorganic fabric contains glass cloth.

37. The method of manufacturing a wiring board according to Claim 25, wherein the inorganic filler contains at least either silica filler or glass filler.

38. The method of manufacturing a wiring board according to Claim 26, wherein the inorganic filler contains at least either silica filler or glass filler.

39. The method of manufacturing a wiring board according to Claim 25, wherein on the first substrate (1), a conductive pattern is formed; on the second substrate (2), a conductive pattern is formed; and the conductive pattern on the first substrate (1) and the conductive pattern on the second substrate (2) are connected via a through-hole (63).

40. The method of manufacturing a wiring board according to Claim 26, wherein on the first substrate (1), a conductive pattern is formed; on the second substrate (2), a conductive pattern is formed; and the conductive pattern on the first substrate (1) and the conductive pattern on the second substrate (2) are connected via a through-hole (63).

41. The manufacturing method of wiring board (19) according to Claim 27, wherein on the inner surface of the via (44), a conductive layer is formed by plating, and the via (44) is filled with metal.

42. The manufacturing method of wiring board (19) according to Claim 28, wherein on the inner surface of the via (44), a conductive layer is formed by plating, and the via (44) is filled with metal.

43. The manufacturing method of wiring board (19) according to Claim 27, wherein on the inner surface of the via (44), a conductive layer is formed by plating, and the via (44) is filled with resin.

44. The manufacturing method of wiring board (19) according to Claim 28, wherein on the inner surface of the via (44), a conductive layer is formed by plating, and the via (44) is filled with resin.

45. The manufacturing method of wiring board (19) according to Claim 25, wherein the first substrate (1) is structured with a lower-layer insulation layer and an upper-layer insulation layer, and the second substrate (2) is structured with a lower-layer insulation layer and an upper-layer insulation layer.

46. The manufacturing method of wiring board (19) according to Claim 26, wherein the first substrate (1) is structured with a lower-layer insulation layer and an upper-layer insulation layer, and the second substrate (2) is structured with a lower-layer insulation layer and an upper-layer insulation layer.

47. The manufacturing method of wiring board (19) according to Claim 45, wherein on the upper-layer insulation layer, a conductive pattern is formed; on the lower-layer insulation layer, a conductive pattern is formed; and the conductive pattern on the upper-layer insulation layer and the conductive pattern on the lower-layer insulation layer are connected through vias (44).

48. The manufacturing method of wiring board (19) according to Claim 46, wherein on the upper-layer insulation layer, a conductive pattern is formed; on the lower-layer insulation layer, a conductive pattern is formed; and the conductive pattern on the upper-layer insulation layer and the conductive pattern on the lower-layer insulation layer are connected through vias (44).
